# EUROPEAN PATENT APPLICATION

(11) **EP 4 554 347 A1**
(43) Date of publication of application: **14.05.2025**
(21) Application number: 23209006.8
(22) Date of filing: 10.11.2023
(51) Int. Cl.: H05K 7/20, H05K 1/02, H01L 23/40

(54) **PRINTED CIRCUIT BOARD ASSEMBLY**

(71) Applicant: Rolls-Royce Deutschland Ltd & Co KG, 15827 Blankenfelde-Mahlow (DE)
(72) Inventor: WALTRICH, Uwe, 15827 Blankenfelde-Mahlow (DE); DIPENKUMAR, Patel, 15827 Blankenfelde-Mahlow (DE); HEGEDUS-FUCHS, Gergely Laszlo, 15827 Blankenfelde-Mahlow (DE)
(74) Representative: Müller, Wolfram Hubertus

(57) **Abstract**

The invention regards a printed circuit board assembly which comprises a printed circuit board (1) having an upper side (11) and a lower side (12), at least one electrical module (2) having an upper side (21) and a lower side (22), the electrical module (2) being arranged with its upper side (21) on the lower side (12) of the printed circuit board (1), and a holding down construction (9) for the printed circuit board (1), the holding down construction comprising screwing posts (92) which are configured to be screwed against the printed circuit board (1). It is provided that the holding down construction (9) is arranged on the upper side (11) of the printed circuit board (1) and comprises contact structures which are at a distance from the screwing posts (92) and configured to rest or press on the printed circuit board (1) at specific contact points (95) only, wherein the printed circuit board (1) comprises dedicated support points (15) that correspond to the specific contact points (95) of the holding down construction (9) and are contacted by the specific contact points (95), wherein the dedicated support points (15) are mechanically reinforced.

## Description

### Field of the disclosure

The present disclosure relates to a printed circuit board assembly.

### Background

It is known to press printed circuit board (PCB) based power electronics devices to a heat sink for cooling, whereby the power electronics devices to be cooled are typically designed as surface-mounted devices (SMD) or through-hole technology (THT) devices and located on the underside of the PCB. To compensate for height tolerances, it is further known to press such PCB based power electronics devices against a heat sink through a thermal interface material. As such thermal interface material reduces the cooling performance compared to a direct contact, there is a desire to reduce the thickness of such thermal interface material to the extent possible.

The use of holding down clamps represents an effective means to limit the deformation of a printed circuit board. Deformation such as a bending of a printed circuit board may be caused by thermomechanical or vibrational expansion. Preventing deformation of the printed circuit board alone already leads to an increase in lifetime and reliability. Further, by limiting the deformation of a printed circuit board through a holding down clamp, tilting of the power electronics devices attached to the underside of the PCB is reduced. Such tilting and the variation in height of the power electronics device associated with it requires an increased tolerance range of a gap between the heat sink and the power electronics device in which the thermal interface material is arranged. However, an increased thickness of the gap and of the thermal interface material is associated with an increased thermal resistance. Accordingly, there is a need to limit the thickness of the gap between the heat sink and the power electronics device and reduce the required tolerance range.

One way to achieve this is to improve the holding down clamp to avoid deformation of the printed circuit board. However, there are limitations on the design of a holding down clamp as the holding down clamp should not overly determine the design of the printed circuit board. In particular, the number of screw connections with which the holding down clamp is connected to the printed circuit board and the heat sink should be as low as possible in order to not restrict the PCB layout too much.

The problem underlying the present invention is to provide for a printed circuit board assembly with a construction which allows to effectively reduce bending of a printed circuit board without overly limiting the layout possibility of the printed circuit board.

This problem is solved by a printed circuit board assembly with the features of claim 1. Embodiments of the invention are identified in the dependent claims.

### Summary of the disclosure

According to an aspect of the invention, a printed circuit board assembly is provided. The printed circuit board assembly comprises a printed circuit board having an upper side and a lower side, at least one electrical module having an upper side and a lower side, the electrical module being arranged with its upper side on the lower side of the printed circuit board, and a holding down construction for the printed circuit board, the holding down construction comprising screwing posts configured to be screwed against the printed circuit board.

It is further provided that the holding down construction is arranged on the upper side of the printed circuit board and comprises contact structures which are configured to rest or press on the printed circuit board at specific contact points only, wherein the contact structures are different from and at a distance from the screwing posts. At the same time, the printed circuit board comprises dedicated support points that correspond to the specific contact points of the holding down construction and are contacted by the specific contact points, wherein the dedicated support points are mechanically reinforced.

Aspects of the invention are thus based on the idea of providing a holding down construction that asserts a pressure on the upper surface of the printed circuit board at specific points only and to provide at same time a printed circuit board upper surface which is mechanically reinforced at those points which receive a pressure from the holding down construction. By providing for a holding down construction which contacts the printed circuit board at specific points only, the area of the printed circuit board which lies against the holding down construction can be reduced such that the printed circuit board layout is less limited by the holding down construction. Also, by asserting a pressure on the upper surface of the printed circuit board at specific points which are located at a distance from the screwing posts, the number of pressure points can be maintained or even increased such that bending of the printed circuit board is effectively reduced while limiting the number of screwing posts and corresponding holes in the printed circuit board to a minimum, this further reducing constraints on the layout of the printed circuit board. Reinforcing the dedicated support points on the printed circuit board which receive the pressure from the holding down construction allows to effectively guide the received pressure into the printed circuit board and avoids wear and tear at the pressure points.

A further advantage associated with the present invention lies in that by providing effective means that inhibit or reduce bending of the printed circuit board, the height of a gap between a heat sink and the underside of the electrical modules can be limited and tolerances can be reduced. This further allows to implement a thermal interface material of reduced thickness, this leading to an improved heat transfer into the heat sink. Also, the reliability of the thermal coupling is improved.

It should be noted that, for the purposes of the present invention, the side of the holding down construction facing the printed circuit board is always referred to as the lower side of the holding down construction, regardless of the actual spatial orientation of the holding down construction and of the printed circuit board. The same manner, the side of the electrical module which faces the printed circuit board is always referred to as the upper side of the electrical module.

In an embodiment of the present invention, the contact structures which are configured to rest or press on the printed circuit board are formed as pushing pins. The pushing pins are configured to punctually assert a pressure against the printed circuit board, wherein the specific contact points that lie or press against the dedicated support points of the printed circuit board are formed by the face sides of the pushing pins. The pushing pins may be cylindrical. They may be arranged on ribs formed by the holding down construction. Such ribs may form a grid-like basic structure which comprises both the screwing posts and the pushing pins.

The dedicated support points which are mechanically reinforced may be reinforced in a plurality of manners. Reinforcement generally means that means are provided in addition to the printed circuit board material that provide for improved mechanical resistance. According to an embodiment, the dedicated support points are mechanically reinforced by at least one metal layer. In a refinement of such embodiment, the dedicated support points are mechanically reinforced by a layer structure of the printed circuit board, the layers of the layer structure being metal layers, wherein the metal layers are not current-carrying layers. The purpose of the metal layers is thus to provide for the dedicated support points, without having any influence on the current carrying layers of the printed circuit board.

To further improve the quality of the reinforcement, it is provided for in an embodiment that the mechanically reinforcing layer structure comprises at least two upper metal layers connected by vias. By providing vias, which are also metallized, that connect the at least two metal layers, the assembly is mechanically stiffened.

In an embodiment, the metal layers are coppers layers. In other embodiments, they are provided by a different metal such as aluminum or an aluminum alloy.

Generally, the one or more metal layers which form the mechanically reinforced dedicated support points on the surface of the printed circuit board are limited in extension to a limited area which receives the pressure from the specific contact points. For example, the layers may be formed as metal pads which have a circular or rectangular form.

In a further embodiment, the electrical modules are arranged on the underside of the circuit board in parallel rows, wherein at least two of the parallel rows form assemblies of each four electrical modules arranged in a rectangular pattern, and wherein each assembly of four electrical modules is associated with one dedicated support point on the upper side of the printed circuit board. Such embodiment uses one dedicated support point and, accordingly, one contact point of the holding down construction only to push down the printed circuit board in an area in which a total of four electrical modules are located, thus pressing these four electrical modules against the heat sink. Thereby, the number of contact points of the holding down construction and corresponding dedicated support points on the printed circuit board is much less than the number of electrical modules.

In a refinement of such embodiment, the dedicated support points on the upper side of the printed circuit board are positioned in such a way that each of the respective opposite points on the lower side of the printed circuit board lies centrally between the four electrical modules of an assembly. By such central location between four electrical modules, the received pressure is provided evenly to all four electrical modules of a considered assembly.

In a further embodiment, the holding down construction is configured to rest against the upper side of the printed circuit board without providing a pressure on the printed circuit board when the printed circuit board is not bent. Accordingly, a counterforce which acts onto the printed circuit board is only provided for by the holding down construction if the printed circuit board starts to bend towards the holding down construction. By such a counterforce, a lifting of the printed circuit board in the upward direction, away from the heat sink, is prevented.

In a further embodiment, the holding down construction is configured to press on the printed circuit board under provision of a preload, the preload providing a force acting on the printed circuit board even when the printed circuit board is not bent towards the holding down construction. In this embodiment, the holding down construction always provides a pressure on the printed circuit board through its contact points. Thereby, the printed circuit board is pressed downward punctually. This embodiment is associated with the advantage that by the pressure on the printed circuit board the height of the gap between the upper surface of the heat sink and the lower surface of the electrical module is reduced. Also, a stronger force is generated which inhibits the printed circuit board from lifting upwards.

In an embodiment, to provide for a preload on the printed circuit board, the pushing pins have a length such that they press on the upper side of the printed circuit board even if the upper side is flat and not bent.

In a further embodiment, the printed circuit board assembly further comprises a heat sink having an upper side, a gap between the upper side of the heat sink and the lower side of the electrical module, and a heat-conducting material, wherein the heat-conducting material is arranged in the gap and wherein the at least one electrical module is thermally coupled at its lower side to the heat sink through the heat-conducting material. According to the invention, such gap can be minimized by providing for an effective holding down construction.

In an embodiment, the dedicated support points on the printed circuit board have a circular or rectangular form. However, in principle, they may have different forms as well such as an elliptical form. The dedicated support points have a closed perimeter.

In a further embodiment, the printed circuit board assembly further comprises a positioning system that positions the holding down construction with respect to the printed circuit board, wherein the positioning system comprises pre-assembly features in the holding down construction and in the printed circuit board. By implementing a positioning system, tolerances are reduced which in turn allows to reduce the area of the dedicated support points on the printed circuit board. By reducing the area of the dedicated support points, additional space is provided for the layout of the printed circuit board and components located thereon.

In an embodiment, the positioning system comprises two positioning pins that are arranged in the heat sink and as - pre-assembly features - positioning holes in the printed circuit board and in the holding down construction, wherein the positioning pins extend from the heat sink through the printed circuit board positioning holes and the holding down construction positioning holes. Accordingly, tolerances are reduced by orienting the printed circuit board and the holding down construction in accordance with two positioning pins fixed to the heatsink, wherein the positioning pins pass through holes in the printed circuit board and in the holding down construction.

The implementation may be such that the holes in the printed circuit board and in the holding down construction that serve to pass one of the pins through are circular, and that the holes in the printed circuit board and in the holding down construction that serve to pass the other of the pins through are oblong holes. The circular holes provide for an exact positioning point of the holding down construction with respect to the printed circuit board, wherein the oblong holes provided for a second positioning point, the oblong shape taking into account potential small tolerances in the position of the preassembly features (the holes) in the holding down construction and in the printed circuit board.

The holding down construction may be designed as a 3D printed part. However, other forms of manufacture such as casting or injection molding are possible as well.

In embodiments, the electrical modules each comprise a power semiconductor device. The electric contacts of the electrical modules are located at the upper side and electrically connected to respective electric contacts at the lower side of the printed circuit board. For example, each electrical module comprises three electric contacts in the form of solder pads at the upper side which provide for a gate voltage, a drain voltage and a source voltage for the power semiconductor device. At the lower side, the electrical module may form a thermal interface which is electrically insulated from the power semiconductor device. To this end, one or several ceramic layers may be included in the electrical module. Such electrical modules are also referred to as prepackage modules. The thermal interface of the electrical module may be thermally coupled to a heat sink. A thermal interface material may be arranged between the thermal interface of the electrical module and the heat sink.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### Brief description of the disclosure

The invention will be explained in more detail on the basis of exemplary embodiments with reference to the accompanying drawings in which:

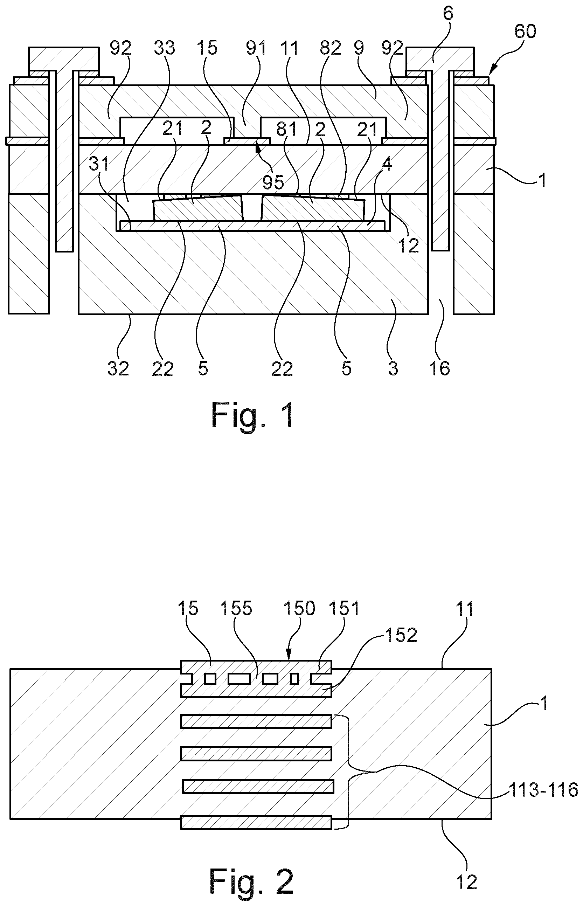

- Figure 1: is an embodiment of a printed circuit board assembly comprising a printed circuit board and a holding down construction, wherein the holding down construction comprises a contact structure which rests on the printed circuit board at a specific contact point, and wherein the printed circuit board comprises a mechanically reinforced support point corresponding to the specific contact point;
- Figure 2: is an enlarged view of an example embodiment of the mechanically reinforced support point of Figure 1;

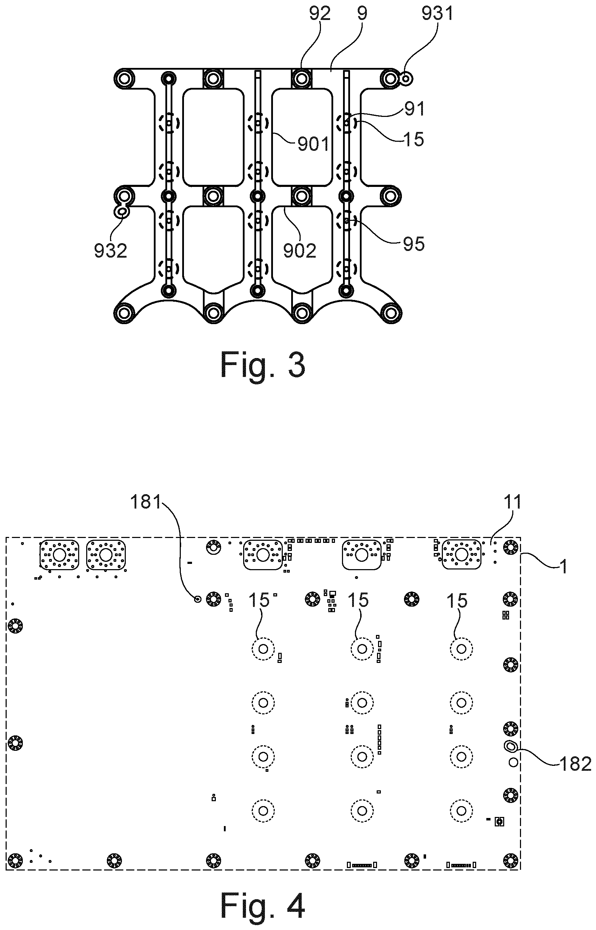

- Figure 3: shows an example holding down construction for a printed circuit board assembly, the holding down construction comprising ribs on which pushing pins are arranged as contact structure;
- Figure 4: is a top view of an example printed circuit board which comprises a plurality of mechanically reinforced support points;

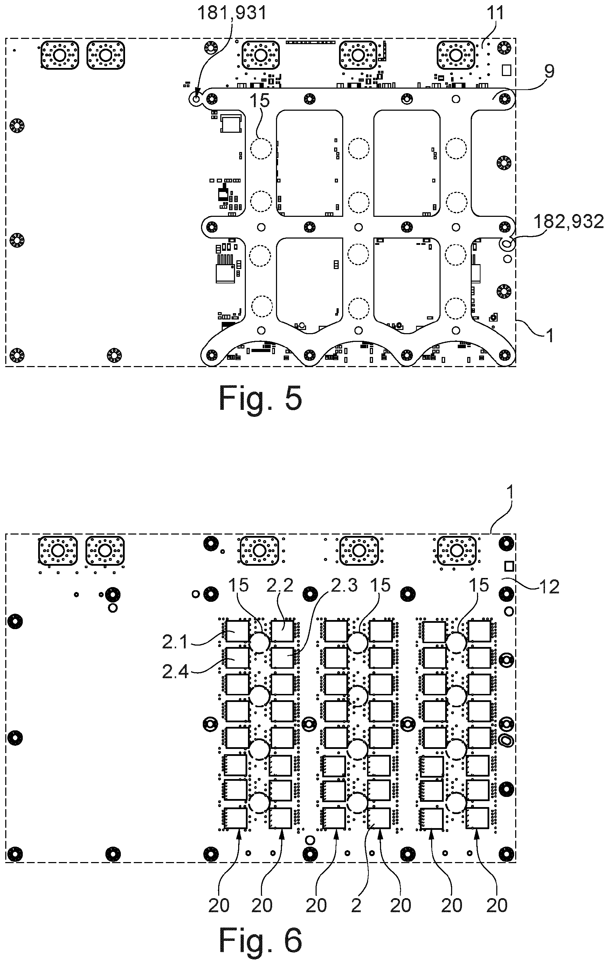

- Figure 5: is a top view on the printed circuit board of Figure 4 when the holding down construction of Figure 3 is connected to the printed circuit board;
- Figure 6: is a bottom view of the printed circuit board of Figures 3 and 4, wherein a plurality of electrical modules are arranged in several rows on the lower side of the printed circuit board, whereby the mechanically reinforced support points on the upper side of the printed circuit board are also shown schematically;

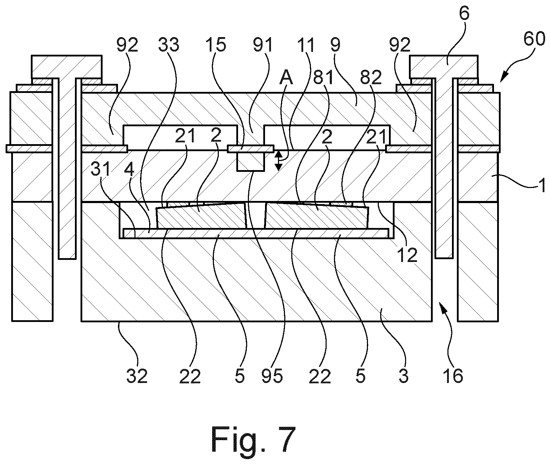

- Figure 7: is a further embodiment of a printed circuit board assembly comprising a printed circuit board and a holding down construction, wherein the holding down construction comprises a contact structure which presses on the printed circuit board at a specific contact point, and wherein the printed circuit board comprises a mechanically reinforced support point corresponding to the specific contact point;

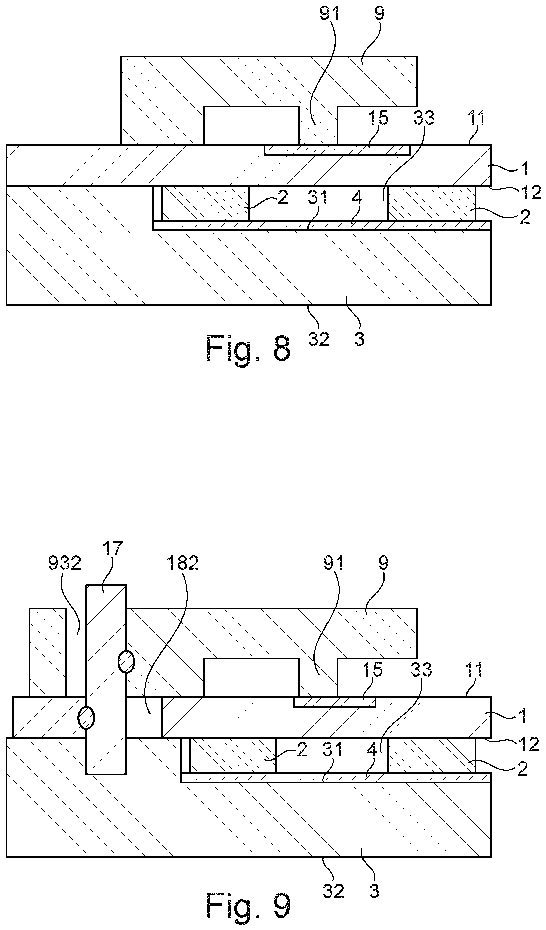

- Figure 8: shows schematically a section of a printed circuit board assembly similar to that of Figure 1, wherein a dedicated support point of the printed circuit board against which a pushing pin of the holding down construction rests is depicted with an exaggerated size which is due to tolerances; and
- Figure 9: shows schematically a section of a printed circuit board assembly similar to that of Figure 1, wherein the printed circuit board assembly additionally includes a tolerance reducing positioning system that comprises pins attached to the heat sink and holes in the printed circuit board and in the holding down construction.

### Detailed description

Figure 1 shows a printed circuit board assembly comprising a printed circuit board 1 having an upper side 11 and a lower side 12, electrical modules 2 having an upper side 21 and a lower side 22, and a heat sink 3 having an upper side 31 and a lower side 32.

The printed circuit board 1 comprises a plurality of printed circuit board layers (not shown separately) arranged one above the other, the uppermost printed circuit board layer forming the upper side 11 and the lowermost printed circuit board layer forming the lower side 12.

The electrical modules 2 are arranged with their upper side 21 on the lower side 12 of the printed circuit board 1. Figure 1 shows two electrical modules 2, but this is only to be understood as an example. On the one hand, several such electrical modules 2 can be arranged one behind the other thereby forming rows (whereby the other electrical modules of a row are not visible in Figure 1), on the other hand, a different number of electrical modules 2 or rows of electrical modules 2 can be arranged next to each other.

The connection of an electrical module 2 to the printed circuit board 1 is made, for example, by surface mounting. In this case, electrical contacts on the upper side of the electrical module 2 (not shown separately) are electrically connected to corresponding electrical contacts on the lower side 12 of the printed circuit board 11 (not shown separately) via solder connections 81, 22. For example, each electrical module 2 comprises electrical contacts for a source terminal, a gate terminal and a drain terminal of the electrical module 2.

Between the upper side 22 of the electrical module 2 and the lower side 12 of the printed circuit board 1 is a gap caused by the solder connections 81, 82 is present which is filled with an underfill material (not shown separately).

The electrical module 2 may be formed in a variety of ways. In embodiments, it includes a semiconductor device, in particular a power semiconductor such as, for example, a power MOSFET or an IGBT device. The semiconductor device is arranged, for example, on a ceramic carrier (not shown separately) which serves to electrically insulate the semiconductor component from the heat sink and at the same time to thermally connect it to the heat sink. The electrical module 2 is also referred to as a prepackage module.

The electrical modules 2 are typically not completely horizontally aligned, but are arranged tilted on the underside of the printed circuit board 1. In particular, such tilting is present due to a bending of the printed circuit board 1 caused by thermomechanical or vibrational expansion, while other factors such as an unequal thickness of the solder with which the electrical modules 2 are electrically connected on the underside of the printed circuit board 1 also play a role.

The electrical modules 2 require cooling by the heat sink 3. For this purpose they are arranged in a cavity or recess 33 of the heat sink 3. The modules 2 to be cooled protrude into the recess 33 and come into thermal contact with the heat sink 3 on their underside through a thermal interface material 4, which is located in a gap 5 between the upper side 31 of the heat sink 3 and the low side 22 of the electrical module 2. By preventing or reducing deformation of the printed circuit board 1, the height of the gap 5 can be constructed to be small, thereby maximizing a heat flow from the electrical modules 2 into the heat sink 3.

In order to reduce or avoid deformation of the printed circuit board 1 (with the consequence that the gap 5 and the thermal interface material 4 arranged therein can be designed to have a small thickness), the printed circuit board arrangement further comprises a holding down construction 9, in the following also referred to as holding down clamp. The holding down clamp 9 comprises screwing posts 92 which allow screws 6 to connect the holding down clamp 9 with the printed circuit board 1 and the heat sink 3. The screws 6 are screwed into through holes 16 which extend from the holding down clamp 9 over the printed circuit board 1 into the heat sink 3. The screws 6 bear on the top side of the holding down clamp 9 via washers and/or mentalizations 60. By means of the screws 6 the holding down clamp 9 is pressed against the upper side of the printed circuit board 1 and, consequently, the electrical modules 2 are pressed against the heat sink 3.

The holding down clamp 9 further comprises contact structures which are formed by a pushing pin 91. The pushing pin 91 is arranged at a distance from the screwing posts 92. There may be provided several such pushing pins 91 at a distance to each other. The pushing pin 91 comprise a lower face side 95 which rests on the printed circuit board upper surface 11 when the printed circuit board 1 is not bent upwards and punctually asserts a pressure against the printed circuit boards when the printed circuit boards is bending upwards. The lower face side 95 represents a contact point of the holding down construction 9 for contacting the printed circuit board upper surface 11.

Further, the printed circuit board 1 comprises a dedicated support point 15 which corresponds in location to the specific contact point 95, wherein the lower face side 95 of the pushing pin 91 rests against the dedicated support point 15. The dedicated support point 15 is mechanically reinforced as will be discussed with respect to Figure 2.

In case the printed circuit board 1 is flat/not bent, the holding down clamp 9 does not provide a force on the printed circuit board 1. However, a punctual counterforce is provided in case the printed circuit board 1 bends upwards due to a deformation, thereby avoiding or reducing a lifting and bending of the printed circuit board 1 away from the heat sink 3.

The heat sink 3 may be made of a metal such as aluminium or an aluminium alloy and may have cooling fins (not shown). The heat sink 3 may be an active heat sink which is actively cooled by a fan or by liquid cooling or may alternatively be a passive heat sink.

Figure 2 shows an embodiment of the mechanical reinforcement of the dedicated support point 15. In Figure 2, the printed circuit board 1 is shown only. It comprises an upper side 11 and a lower side 12. Further, it comprises a plurality of current carrying copper layers 113-116 and isolating layers in between in a usual manner known to the skilled person. To implement a reinforcement of the support points 15, a layer structure 150 is provided for in the area of the support point 15. The layer structure 150 comprises two upper copper layers 151, 152 which are connected vertically by means of metallized vias 155, wherein upper layer 151 is on the upper side 12 of the printed circuit board 1. By providing several copper layers 151, 152 at the top surface of the printed circuit board, the support point 15 is mechanically reinforced. A further stiffening and mechanical reinforcement is achieved by the vertical vias 155.

It is pointed out that the layer structure 150 with layers 151, 152 and vias 155 does not serve to guide any current. The layers 151, 152 are not current-carrying layers and not electrically connected to the other layers 113-116 of the printed circuit board. The layers 151, 152 may have the form of circular or rectangular pads of limited size.

Figure 3 shows an example of a holding down clamp 9 in a view on the bottom side of the holding down clamp. The holding down clamp 9 comprises a grid-like basic structure which is formed by first ribs 901 and second ribs 902 generally arranged in a perpendicular manner. The holding down clamp 9 further comprises screwing posts 92 which are configured to be screwed against a printed circuit board and a heat sink, as discussed with respect to Figure 1. To this end, the screwing posts 92 are configured to receive a screw that allows them to be screwed onto a printed circuit board and heat sink. The screwing posts 92 are attached to the second ribs 902 and arranged at a distance to each other.

The holding down clamp 9 further comprises contact structures which are attached to the lower side of the basic structure, thus facing the printed circuit board. The contact structures provide for a downward pressure on the printed circuit board that inhibits the printed circuit board to bend towards the holding down clamp 9. In the depicted embodiment, the contact structures are formed as pins 91, also referred as pushing pins 91 as they push against the printed circuit board. The pushing pins 91 are arranged along the first ribs 901 and at a distance to each other. In other embodiments, pushing pins 91 may be provided along the second ribs 902 additionally or alternatively.

In Figure 3, in addition to the pushing pins 91, the location of the corresponding dedicated support points 15 on the top surface of a printed circuit board to which the holding down clamp 9 is connected is also shown to indicate the positional relationship.

The holding down clamp 9 further comprises as pre-assembly features a positioning hole 931 which is circular and a further positioning hole 932 which is oblong, as will be discussed with respect to Figure 9.

The holding down clamp 100 may be formed by 3D-printing.

Figure 4 is a top view on an example printed circuit board 1, wherein the upper surface 11 of the printed circuit board 1 is visible. On the upper surface 11 a plurality of mechanically reinforced support points 15 are implemented. The reinforced support points 15 may be formed as shown in Figure 2 or in any other manner providing for a reinforcement of the support points 15. Other reinforcement means may comprise one or several non-metal layers such as a resin having a mechanical strength higher than that of typical printed circuit board isolating layer material (such as glass-reinforced epoxy laminate material FR4).

The printed circuit board 1 further comprises as pre-assembly features a positioning hole 181 which is circular and a further positioning hole 182 which is oblong, as will be discussed with respect to Figure 9.

Figure 5 shows the holding down clamp 9 of Figure 3 when arranged on the upper side 11 of the printed circuit board 1 of Figure 4, wherein the mechanically reinforced support points 15 are also indicated (while in fact being concealed by the holding down clamp 9). The pusher pins 91 punctually assert a pressure against the printed circuit board 1 when the printed circuit board 1 bends towards the holding down clamp 9.

As can be seen in Figure 5, the positioning holes 181, 182 of the printed circuit board 1 and the positioning holes 931, 932 of the holding down construction 9 are arranged above each other when the holding down clamp 9 is arranged on the upper side 11 of the printed circuit board 1. Two pins extend through holes 181, 931 and 182, 932 as will be discussed with respect to Figure 9.

Figure 6 shows the lower side 12 of the printed circuit board 1 of Figures 4 and 5. On the lower side 12, as discussed before, a plurality of electrical modules 2 are arranged. The electrical modules 2 are arranged in parallel rows 20. More particularly, in the depicted embodiment, electrical modules 2 are arranged in six parallel rows 20 each comprising 8 electrical modules. The electrical modules 2 are interconnected and form, for example, logical switches of a three-phase inverter with three phases U, V, W. However, this is only to be understood as an example.

Figure 6 also indicates the position of the support points 15 which are located on the upper side of the printed circuit board 1. It is provided that each support point 15 is associated with four of the electrical modules 2. The electrical modules 2 of two adjacent rows 20 form a plurality of assemblies each comprising four of the electrical modules arranged in a rectangular pattern. For example, as depicted in Figure 6, one of the support points 15 (or rather its opposite point on the lower side 12 of the printed circuit board 1) lies centrally between the four electrical modules 2.1, 2.2, 2.3 and 2.4 of two adjacent rows 20. This ensures that the printed circuit board 1 is effectively pressed against the heat sink 3 in the area of the electrical modules 2 via the respective pushing pins 91, as shown in Figure 1, while limiting the number of pushing pins 91.

Figure 7 is a further embodiment of a printed circuit board assembly. The printed circuit board assembly of Figure 7 differs from the printed circuit board assembly of Figure 1 in one aspect only, such that for the other aspects and features reference is made to the description of Figure 1. The difference lies in that, while in Figure 1 the pushing pins 91 are configured to rest against the upper side 11 of the printed circuit board without providing a force on the printed circuit board when the printed circuit board is not bent upwards, in Figure 7 the pushing pins 91 provide a preload on the printed circuit board 1 even if the printed circuit board 1 is not bending towards the holding down clamp 9.

To achieve such a preload, the pushing pins 91 are longer than in Figure 1. The increase in length of the pushing pins 91 compared to the embodiment of Figure 1 may be in the range between 0.1 mm and 0.5 mm. The pushing pins 91 comprise a length such that they press on the upper side 11 of the printed circuit board 1 even if the upper side 1 is not bent towards the holding down clamp 9. Thereby, the printed circuit board 1 is punctually pressed downward towards the heat sink 3 such that the distance between the heat sink 3 and the lower side 2 of the electrical modules 2 (i.e., the height of the gap 5) is reduced.

It is pointed out that Figure 7 is schematic in that it only shows pushing pins 91 of increased length, without showing the corresponding bending and vertical movement of the printed circuit board 1 and of the support points 15. Arrow A indicates that the vertical position of the lower face side 95 (which is the contact point of the pushing pin 91 with the upper surface 11 of the printed circuit board 1) changes depending on the bending status of the printed circuit board 1.

Figure 8 shows a section of a printed circuit board assembly similar to that of Figure 1 depicting a holding down construction 9 comprising a pushing pin 91 that rests against or presses on the upper side 11 of a printed circuit board 1 at a dedicated support point 15 which is mechanically reinforced. Figure 8 further shows schematically two electrical modules 2 located at the lower side 12 of the printed circuit board 1, a heat conducting material 4 and a heat sink 3, the heat sink 3 having a cavity 33, an upper side 31 and a lower side 32.

Due to tolerances in the relative positions of the holding down construction 9 and the printed circuit board 1 the dedicated support points 15 which are contacted by the pushing pins 91 may need to have a larger area than desired (as schematically illustrated in Figure 8), thereby reducing space for the printed circuit board layout and components attached to the printed circuit board.

To reduce the tolerances and allow to shrink the size of the area of the dedicating support points 15, a tolerance reducing positioning system is provided in the embodiment of Figure 9. The positioning system makes use of the pre-assembly features 181, 182, 931, 932 of the printed circuit board 1 and of the holding down construction 9 shown in Figures 3, 4 and 5, wherein in Figure 9 only the pre-assembly features 182, 932 are depicted. More particularly, two positioning pins 17 are formed by or attached to the heat sink 9, wherein one of the positioning pins 17 is depicted in Figure 9. The depicted positioning pin 17 extends from the heat sink 3 through the positioning hole 182 in the printed circuit board 1 and through the positioning hole 932 in the holding down construction 9. In a similar manner, the other positioning pin extends from the heat sink 3 through positioning hole 181 of the printed circuit board 1 and positioning hole 932 of the holding down construction 9 (see Figures 3, 4 and 5).

Further, as discussed before, the positioning holes 182, 932 are oblong, wherein the other positioning holes 181, 131 are circular. This allows to fix the relative position between the holding down construction 9 and the printed circuit board 1 with minimal tolerances, thereby allowing the area of the mechanically reinforced support points 15 to be minimal, as is schematically shown in Figure 9. Further, the dimensions are defined such to ensure a minimum clearance in all tolerance cases.

It should be understood that the above description is intended for illustrative purposes only, and is not intended to limit the scope of the present disclosure in any way. Also, those skilled in the art will appreciate that other aspects of the disclosure can be obtained from a study of the drawings, the disclosure and the appended claims. All methods described herein can be performed in any suitable order unless otherwise indicated herein or otherwise clearly contradicted by context. Various features of the various embodiments disclosed herein can be combined in different combinations to create new embodiments within the scope of the present disclosure. In particular, the disclosure extends to and includes all combinations and sub-combinations of one or more features described herein. Any ranges given herein include any and all specific values within the range and any and all sub-ranges within the given range.

## Claims

1. A printed circuit board assembly comprising:
- a printed circuit board (1) having an upper side (11) and a lower side (12),
- at least one electrical module (2) having an upper side (21) and a lower side (22), the electrical module (2) being arranged with its upper side (21) on the lower side (12) of the printed circuit board (1),
- a holding down construction (9) for the printed circuit board (1), the holding down construction comprising screwing posts (92) which are configured to be screwed against the printed circuit board (1),
- wherein the holding down construction (9) is arranged on the upper side (11) of the printed circuit board (1) and comprises contact structures (91) which are at a distance from the screwing posts (92) and configured to rest or press on the printed circuit board (1) at specific contact points (95) only,
- wherein the printed circuit board (1) comprises dedicated support points (15) that correspond to the specific contact points (95) of the holding down construction (9) and are contacted by the specific contact points (95),
- wherein the dedicated support points (15) are mechanically reinforced.

2. The printed circuit board assembly of claim 1, **characterized in that** the contact structures (3) which are configured to rest or press on the printed circuit board (1) are formed as pushing pins (91) configured to punctually assert a pressure against the printed circuit board (1), wherein the specific contact points (95) are formed by the face sides of the pushing pins (91) which rest against the dedicated support points (15) of the printed circuit board (1).

3. The printed circuit board assembly of claim 1 or 2, **characterized in that** the pushing pins (91) are arranged on ribs (901) formed by the holding down construction (9).

4. The printed circuit board assembly of any of claims 1 to 3, **characterized in that** the dedicated support points (15) are mechanically reinforced by at least one metal layer (151, 152).

5. The printed circuit board assembly of claim 4, **characterized in that** the dedicated support points (15) are mechanically reinforced by a layer structure (150), the layers of the layer structure (150) being metal layers (151, 152), wherein the metal layers (151, 152) are not current-carrying layers.

6. The printed circuit board assembly of claim 5, **characterized in that** the mechanically reinforcing layer structure (150) comprises at least two upper metal layers (151, 152) connected by vias (155).

7. The printed circuit board assembly of any of the preceding claims, **characterized in that** the electrical modules (2) are arranged on the lower side (12) of the circuit board (1) in parallel rows (20), wherein at least two of the parallel rows (20) form assemblies of each four electrical modules (2) arranged in a rectangular pattern, and wherein each assembly of four electrical modules (2) is associated with one dedicated support point (15) on the upper side (11) of the printed circuit board (1).

8. The printed circuit board assembly of claim 7, **characterized in that** the dedicated support points (15) on the upper side (11) of the printed circuit board (1) are positioned in such a way that each of the respective opposite points on the lower side (12) of the printed circuit board (1) lies centrally between the four electrical modules (2) of an assembly.

9. The printed circuit board assembly of any of the preceding claims, **characterized in that** the holding down construction (9) is configured to rest against the upper side (11) of the printed circuit board (1) without providing a pressure on the printed circuit board (1) when the printed circuit board (1) is not bent towards the holding down construction (9).

10. The printed circuit board assembly of any of claims 1 to 8, **characterized in that** the holding down construction (9) is configured to press on the printed circuit board (1) under provision of a preload, the preload providing a force acting on the printed circuit board (1) even when the printed circuit board (1) is not bent towards the holding down construction (9).

11. The printed circuit board assembly of claim 10, as far as referring to claim 2, **characterized in that** the pushing pins (91) have a length such that they press on the upper side (11) of the printed circuit board (1) even if the upper side (1) is not bent.

12. The printed circuit board assembly of any of the preceding claims, **characterized in that** the printed circuit board assembly further comprises:
- a heat sink (3) having an upper side (31),
- a gap (5) between the upper side (31) of the heat sink (3) and the lower side (22) of the electrical module (2),
- a heat-conducting material (4),
- wherein the heat-conducting material (4) is arranged in the gap (5), and
- wherein the at least one electrical module (2) is thermally coupled at its lower side (22) to the heat sink (3) through the heat-conducting material (4).

13. The printed circuit board assembly of any of the preceding claims, **characterized by** a positioning system that positions the holding down construction (9) with respect to the printed circuit board (1), wherein the positioning system comprises pre-assembly features (181, 182, 931, 932) in the printed circuit board (1) and in the holding down construction (9).

14. The printed circuit board assembly of claim 13, as far as referring to claim 12, **characterized in that** the positioning system comprises two positioning pins (17) that are arranged in the heat sink (3) and positioning holes (181, 182, 931, 932) in the printed circuit board (1) and in the holding down construction (9), wherein the positioning pins (17) extend from the heat sink (3) through the printed circuit board (1) positioning holes (181, 82) and the holding down construction (9) positioning holes (931, 932).

15. The printed circuit board assembly of claim 14, **characterized in that**
- the holes (181, 931) in the printed circuit board (1) and in the holding down construction (9) that serve to pass one of the pins through are circular, and
- the holes (182, 932) in the printed circuit board (1) and in the holding down construction (9) that serve to pass the other of the pins (17) through are oblong holes.
